# EUROPEAN PATENT SPECIFICATION

(11) **EP 2 244 542 B1**
(45) Date of publication and mention of the grant of the patent: **27.03.2013**
(21) Application number: 09158711.3
(22) Date of filing: 24.04.2009
(51) Int. Cl.: H05K 3/38, H05K 3/46

(54) **Multilayer printed circuit board manufacture**
Herstellung einer mehrschichtigen Leiterplatte
Fabrication de carte de circuit imprimé multicouche

(43) Date of publication of application: 27.10.2010
(73) Proprietor: Atotech Deutschland GmbH, 10553 Berlin (DE)
(72) Inventor: Sparing, Christian, 13509 Berlin (DE); Huelsmann, Thomas, 14167 Berlin (DE); Brooks, Patrick, 10707 Berlin (DE); Clicque, Arno, 13435 Berlin (DE)
(74) Representative: Wonnemann, Jörg

(56) References cited:
- EP-A- 0 431 501
- EP-A- 1 037 511
- EP-A- 1 978 024

## Description

### Field of the Invention

The present invention is directed to a process of forming multilayer printed circuit boards, IC substrates, printed circuit boards for high frequency applications and flexible substrates; multilayer printed circuit boards and IC substrates obtainable thereby, an organosilane bonding mixture and a treatment using a composition comprising at least one inorganic silicate. Multilayer PCB's and IC substrates are typically constructed by interleafing imaged conductive layers such as one containing copper with dielectric layers such as a partially cured B-stage resin, i.e., a prepreg, into a multilayer sandwich which is then bonded together by applying heat and pressure. Since a conductive layer with a smooth copper surface does not bond well to the prepreg, rough copper surfaces have been employed to obtain a better bond to a dielectric. Therefore, a portion of the multilayer PCB industry applies a mechanical or chemical roughening process step to assure better bonding. However, as circuit patterns get finer, there is an increasing risk of physically damaging the conductor traces during this surface preparation. Another process employed by the industry to improve bonding between the conductive layer and the dielectric are various copper surface oxidation procedures widely practiced in the plating industry to assure good interphasial adhesion.

In an alternative process, organosilanes are utilized for increasing adhesion between a copper surface and a prepreg surface. Said organosilanes are deposited in thin layers onto the copper surface and during lamination the organosilane molecules bond to the epoxy, i.e., prepreg surface. In order to increase adhesion between said organosilanes and the copper surface said copper surface is precoated with a metal such as tin that reacts with the organosilane. When properly applied, the organosilane treatment is very stable and is resistant to chemical attack and delamination. The organosilane process has the advantage that it can be conveyorized in an inline process system.

Document EP 0 431 501 B1 discloses a process for manufacturing multilayer printed circuit boards using organosilane bonding mixtures applied to oxidized tin surfaces. Said process fails in the manufacture of fine-line IC substrates.

The patent application EP 1 978 024 A1 discloses various mixtures of organosilanes and colloidal silica particles as well as bonding mixtures comprising alkaline silicates and colloidal silica for the manufacture of multilayer printed circuit boards.

The Japanese patent application JP 2007-10780 discloses a process for manufacture of multilayer printed circuit boards wherein an organosilane bonding agent is applied onto for example a layer of palladium.

The major weakness of the processes described in prior art is that organosilane layers can fail in some environments and in manufacturing of IC substrates which have feature sizes of ≤ 20 µm and are manufactured using SAP technology (Semi-Additive Process).

### Summary of the Invention

Therefore it is an object of the present invention to provide a process for forming a multilayer printed circuit board or a IC substrate, especially for those manufactured by SAP technology having very fine circuit structures. The process comprises the steps of
(a) forming electrically conductive copper circuitry on a surface of a dielectric layer support with the circuitry having a thickness of at least 4 µm;
(b) forming on the copper circuitry a layer of an oxide, hydroxide or combination thereof of tin by application of tin to the copper circuitry whereby during application or subsequent thereto the applied tin is converted on its surface to the oxide, hydroxide or combination thereof. Preferably the layer of oxide, hydroxide or combination is not greater than 40 µm in thickness;
(c) applying a mixture comprising at least one inorganic silicate to the surface of the oxide, hydroxide or combination thereof formed in step (b);
(d) applying an organosilane bonding mixture to the layer comprising at least one inorganic silicate formed in step (c);
(e) repeating steps (a), (b), (c) and (d);
(f) bonding materials formed by steps (a), (b), (c), (d) and (e) into a single article whereby an organosilane coating is between a layer of at least one inorganic silicate and an insulating layer whereby during bonding the partially cured insulating layer is cured; and optionally
(g) forming a number of holes through the bonded article formed in step (f);
(h) metallizing walls of the through-holes to form electrically conductive paths from opposite openings of the through-holes to form a multilayer circuit board;
the organosilane bonding mixture comprises:
(i) at least one ureido silane having the structure of formula I 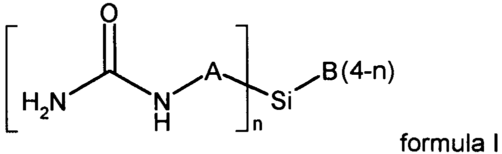 wherein A is an alkylene having 1 to 8 carbon atoms, B is a hydroxyl or an alkoxy having 1 to 8 carbon atoms and n is an integer of 1, 2 or 3 with the provisio that if n is 1 or 2, each B need not be identical; and
(ii) at least one crosslinking agent, selected from the group consisting of compounds having the structure of formula II and formula III, 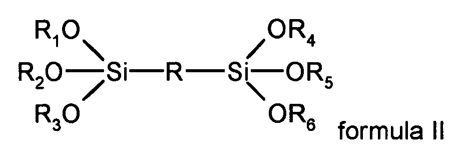 wherein R1, R2, R3, R4, R5 and R6 independently of the other is an alkyl with 1 to 8 carbon atoms and where R denotes an alkylene group having 1 to 8 carbon atoms, and

   Si(OR7)₄ formulaIII

   wherein R7 is selected from the group consisting of methyl, ethyl and propyl and mixtures of compounds having the formula II and III,
   and wherein the overall concentration of the at least one ureido silanes having the structure of formula I and the at least one crosslinking agent ranges between 1 g/l and 50 g/l and to circuit boards and IC substrates obtainable to the above process.

### Detailed Description of the Invention

The present invention is directed to a process for forming a multilayer printed circuit board or a IC substrate as defined in claim 1. The circuit board has alternating layers of dielectric material which support copper circuitry which are adhered to an insulating layer through intermediate layers. The circuit board has through-holes which form electrical paths across the entire thickness of the board.

The process according to the present invention is particularly suitable for circuits with fine line resist structures possessing high-density interconnect (HDI) feature sizes of 50 µm and even 25 µm or lower.

IC substrates are usually manufactured with SAP technology and have line and space feature sizes of ≤ 20 µm. IC substrates are a basic component of IC packages, which, combined with other electronic components in an assembly, control functions of an electronic appliance. IC packages can be broadly divided into single chip modules (or SCMs) and multi-chip modules (or MCMs), with the former containing one IC chip, and the latter containing multiple chips and other electronic devices.

In formation of multilayer circuit boards or IC substrates several dozen conductive and nonconductive layers can be employed. Also, for formation of multilayer circuit boards or IC substrates, it is necessary to drill holes and defects can occur due to delamination of layers in the areas immediately surrounding a hole. If a defect is present in one of the layers or if delamination occurs, generally the entire board or IC substrate must be scrapped. Therefore high quality in each of the steps of formation of the printed circuit board or IC substrate is essential for commercial production. With the techniques, various articles can be formed. Illustratively one article can contain in order, a dielectric layer, a copper circuitry with layer of tin and an oxide, hydroxide or combination thereof of the underlying tin, a layer comprising at least one inorganic silicate, a layer of an organosilane bonding mixture, an insulating layer, a second dielectric layer, a second copper circuitry with a second layer of tin, an oxide, hydroxide or combination thereof of the underlying tin, a second layer comprising at least one inorganic silicate, a second layer of an organosilane bonding mixture and a second insulating layer. In the above article the (first) insulating layer can be contacted to the second dielectric layer directly or through an adhesive layer. Such adhesives are well known in the art, e.g., a high temperature epoxy. In an alternate article the second dielectric layer need not be present with all other layers having the same order. In a further alternate embodiment of the invention a dielectric layer can be present which has copper circuitry on opposite surfaces. Thereafter on the opposite surface the various layers are applied including optionally a layer of tin with an oxide, hydroxide or combination thereof of the underlying tin, inorganic silicate, organosilane bonding mixture and insulating layer.

A starting material in the process of the present invention is a dielectric layer which contains on one or opposite surfaces a cladding of copper. This copper layer is of a thickness of at least 1 µm and more preferably 15 µm and it is used to form conductive circuitry. Well-known techniques in the prior art can be employed to form such circuitry such as by photoimaging technique of a photosensitive resist film followed by etching of unprotected areas of the copper. An example of a suitable technique is disclosed in U.S. Patent 3,469,982. The composition of the dielectric layer is not critical provided it functions as an electrical insulator. Useful support materials are disclosed in U.S. Patent 4,499,152 such as epoxy reinforced with glass fiber. Preferably a partially cured thermosetting polymer composition is employed which is known in the art as a prepreg or "B" stage resin.

Useful dielectric substrates or layers may be prepared by impregnating woven glass reinforcement materials with partially cured resins, usually epoxy resins (e.g., difunctional, tetrafunctional and multifunctional epoxies). Epoxy resins are particularly suited. It is an advantage of the organosilane compositions of the present invention that they show very good adhesion on both glass and resin areas of the substrate material, which is often a problem with compositions known from prior art.

Examples of useful resins include amino-type resins produced from the reaction of formaldehyde and urea, or formaldehyde and melamine, polyesters, phenolics, silicones, polyamides, polyimides, di-allyl phthalates, phenylsilanes, polybenzimidazoles, diphenyloxides, polytetrafluoroethylenes, cyanate esters, etc. These dielectric substrates often are referred to as prepregs. An epoxy substrate of the newest generation is Ajinomoto GX-3 and GX-13, which contains glass ball fillers and can also be treated with the process according to the present invention. The insulating layer and the dielectric layer can be prepared by impregnating woven glass reinforcement materials with partially cured resins as described above. Thus, the insulating layer or layers may also be prepregs.

In the formation of multilayer printed circuit boards or IC substrates, several dielectric layers having a conductive metal coating or metal circuitry on at least one surface and several insulating layers may be employed.

After formation of the conductive circuitry, it typically is necessary to form a thin outer layer of an oxide, hydroxide or combination thereof. This layer which is of a thickness not greater than 1.5 µm and more preferably not greater than 1.0 µm can be directly formed by oxidation of the copper circuitry.

In one embodiment of this invention a conductive layer is formed from tin. As will be more fully described below, a preferred technique of application of the coating is by immersion metal plating. The thickness of the metal layer is not critical and can be, e.g., 0.06 to 0.25 µm. During, and subsequent to, the application of tin, a thin coating of an oxide, hydroxide or combination thereof is formed. Since this coating can be extremely thin preferably not greater than 1.5 µm or in some instances only monolayers in thickness, air oxidation can be employed. In such case, the oxide/hydroxide can be formed upon standing at room temperature wherein the copper surface reacts with ambient oxygen and water vapor. Other techniques for formation of the oxide/hydroxide include immersion in or exposure to an oxidative aqueous bath.

A preferred immersion tin coating composition contains a thiourea compound, a tin salt, a reducing agent, an acid and a urea compound. The tin salt preferably comprises a stannous salt. Although stannous salts of an inorganic (mineral) acid or organic acid may be used (e.g., stannous formate and stannous acetate) the tin salt may comprise a stannous salt of a mineral acid such as the sulfur, phosphorous, and halogen acids, especially the sulfur acids such as sulfuric acid or sulfamic acid. Alkali metal stannates may also be used such as sodium or potassium stannate and the art known equivalents thereof. In one embodiment stannous sulfate, stannous sulfamate or stannous acetate is used as the tin salt. Where tin lead coatings are deposited, lead acetate may be used as the lead salt. The acids that are employed may be organic acids or inorganic acids (mineral acids) based on sulfur, phosphorous, or the halogens, the sulfur based acids being preferred such as sulfuric acid, methane sulfonic acid (MSA) or sulfamic acid. Some of the organic acids that may be employed comprise monocarboxylic or dicarboxylic acids having up to about six carbon atoms such as formic acid, acetic acid, malic acid and maleic acid. It is preferred, if possible not to use halogen acids or halogen salts since halide residues will be produced in the tin coating deposited, these salts interfering with the electrical properties of the tin and may also act as corrosive materials in the coating. In one embodiment of the present invention the immersion tin coating composition further comprises at least one chelating agent. Chelating agents that are especially preferred comprise the aminocarboxylic acids and the hydroxycarboxylic acids. Some specific aminocarboxylic acids that may be employed in this respect comprise ethylenediaminetetraacetic acid, hydroxyethylethylenediaminetriacetic acid, nitrilotriacetic acid, N-dihydroxyethylglycine, and ethylene-bis(hydroxyphenylglycine). Hydroxy carboxylic acids that may be employed comprise tartaric acid, citric acid, gluconic acid and 5-sulfosalicylic acid.

The various reducing agents that may be employed are well known in the art and generally comprise organic aldehyde whether saturated or unsaturated, aliphatic or cyclic, having up to ten carbon atoms. Lower alkyl aldehydes having up to six carbon atoms may be employed in this respect such as formaldehyde, acetaldehyde, propionaldehyde, butyraldehyde, and the like. Especially preferred aldehydes comprise hydroxy aliphatic aldehydes such as glyceraldehyde; erythrose; threose; arabinose and the various position isomers thereof and glucose and the various position isomers thereof. Glucose has been found to act to prevent oxidation of the metal salts to a higher oxidation state, e.g., Sm(II) to Sn(IV), but also as a chelating agent and is especially useful for these reasons. The surfactants that may be employed comprise any non-ionic, anionic, cationic or amphoteric surfactant. The nonionic surfactants are especially preferred.

A composition comprising at least one inorganic silicate is applied in step (c) as a coating either to the tin oxide, tin hydroxide or combination The at least one inorganic silicate is selected from water soluble inorganic silicates characterized by the general formula xM₂O · SiO₂ · nH₂O wherein x ranges from 1 to 4, preferably from 1 to 3, n ranges from 0 to 9 and M is selected from the group consisting of Na⁺, K⁺ and NH₄⁺. The concentration of the at least one inorganic silicate ranges from 0.05 g/l to 50 g/l, more preferably from 0.5 g/l to 10 g/l. Optionally, said mixture contains additionally at least one water soluble phosphate which is selected from the group consisting of sodium phosphate, potassium phosphate, ammonium phosphate, dibasic sodium phosphate, tribasic sodium phosphate, dibasic potassium phosphate, tribasic potassium phosphate, ammonium dibasic phosphate, ammonium tribasic phosphate, sodium tripolyphosphate, potassium tripolyphosphate and ammonium tripolyphosphate and the like. The concentration of the at least one water soluble phosphate ranges from 0.05 g/l to 50 g/l, more preferably from 0.5 g/l to 10 g/l.

The composition comprising at least one inorganic silicate is deposited onto the copper layer having an oxidized tin surface by any conventional means, e.g., by dipping, spraying, brushing and immersion. The composition is deposited onto the oxidized tin surface at a temperature in the range of 15°C to 60°C, more preferably 20°C to 40°C.

In one embodiment of the present invention the substrate is dipped into the composition comprising at least one inorganic silicate for 5 s to 100 s, more preferably for 10 s to 30 s.

In still another embodiment, the layer comprising at least one inorganic silicate is not dried prior to deposition of the organisilane bonding mixture.

Next, an organosilane bonding mixture according to the present invention is applied in step (d) as a coating to the layer comprising at least one inorganic silicate. Turning to the organosilane bonding mixture which can be employed in the present invention, it is a requirement that the organosilane bonding mixture forms an adherent intermediate layer which bonds to the layer comprising at least one inorganic silicate and to the partially cured and converted to the fully cured insulating layer. It is a requirement that the layer comprising at least one inorganic silicate and the organosilane bonding mixture function to prevent delamination in accordance with the thermal stress test as defined herein. In a preferred mode the multilayer circuit board with fully cured insulating layer meets all specifications of MIL-P-55110D.

It is considered that the ureido silane forms hydrogen bridge bonds with silanole (SIGH)- groups of the organosilane and/or form covalent metal-O-Si bonds in a condensation reaction. The organosilanes are considered to interact with the adjacent layers through a functionally substituted organic group to provide van der Wals force interaction, strong polar force hydrogen bridge interaction, or covalent bond formation with the dielectric resin. It is considered that the crosslinking agent forms a network with the ureido silane to reduce the moisture sensitivity of the resulting adherent organosilane layer. The moisture resistant, adherent, organosilane layers of this invention are prepared from an organosilane bonding mixture which has as its essential components
(I) at least one ureido silane having a structure according to formula I: 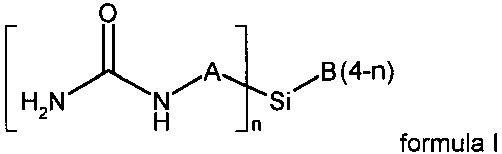 wherein A is an alkylene having 1 to 8 carbon atoms, B is a hydroxy or an alkoxy having 1 to 8 carbon atoms and n is an integer of 1, 2, or 3 with the proviso that if n is 2 or 3, B need not be identical; and (II) at least one crosslinking agent, selected from the group consisting of compounds having the structure according to formula II 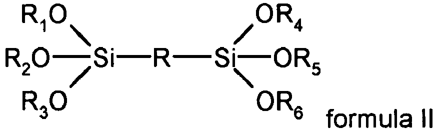 wherein R1, R2, R3, R4, R5 and R6 independently of the other is an alkyl with 1 to 8 carbon atoms and where R denotes an alkylene group having 1 to 8 carbon atoms, compounds having the formula III

   Si(OR7)₄ formula III

   wherein R7 is selected from the group consisting of methyl, ethyl and propyl and mixtures of compounds having the formulas II and III.

Preferably in formula I each B group is identical if more than one B group is present. Also preferably R1, R2, R3, R4, R5 and R6 are identical. In the ureido silane, the alkylene group, A, preferably is a divalent ethylene or propylene and the alkoxy group, B, preferably is a methoxy or ethoxy group. A particularly preferred ureido silane is γ-ureidopropyl-triethoxy-silane. In the crosslinking agent according to formula II, the alkyl group preferably is methyl or ethyl and the alkylene group, R, preferably is a divalent ethylene or propylene group. A particularly preferred crosslinking agent according to formula II is hexamethoxydisilylethane. The component concentrations of the silane bonding mixture may vary widely to meet the needs of a particular application. Thus the weight ratio of the ureido silane to the crosslinking agent may be between 99:1 and 1:99. Preferably the weight ratio of the ureido silane and the crosslinking agent is between 10:1 and 1:1. Typically a single ureido silane is used with a single crosslinking agent, however, it is within the scope of this invention to use in the silane bonding mixture, two or more ureido silanes as defined and/or two or more crosslinking agents as defined. In the practice of this invention the organosilane bonding mixtures may be applied as a liquid solution to the layer comprising at least one inorganic silicate or insulating layer surface. In this instance the organosilane bonding mixture contains a mutual solvent for the ureido silane and the crosslinking agent. The overall concentration of organosilanes ranges between 1 g/l and 50 g/l, more preferred from 2 g/l to 10 g/l. The solution is applied by any conventional means, e.g., by dipping, spraying, brushing and immersion.

The multilayer printed circuit boards or IC substrates prepared as described above may be subjected to conventional lamination temperatures and pressures between plates of lamination presses. In this manner, the laminating operation generally will involve pressures in the range of from 1.72 MPa to 5.17 MPa, temperatures in the range of from 130°C to about 350°C and laminating cycles of from 30 min to 2 h. Alternatively, a vaccum lamination method is used for Build-up films in IC substrates. The laminate is placed on the copper surface, laminated at 100°C and pressed for 30 s by at 3 kg/cm².

The advantages of the process according to the present invention include enhanced adhesion, enhanced oxidation resistance and enhanced moisture resistance, especially for high density interconnects and IC substrates.

### Examples

Test samples used for the experiments are:
(i) full copper board panels built from standard FR4 material layers of 0.8 mm thickness with a copper layer thickness of 35 µm and a size of 310 × 500 mm
(ii) structured board panels having a 1.6 mm thick FR4 single sided structured side with a copper thickness of 35 µm and a size of 200 x 150 mm
(iii) ABF films (Ajinomoto GX13) having a thickness of 32 µm

The copper surface of the test samples (i) and (ii) were chemically cleaned, treated with an immersion tin composition and an organosilane bonding mixture and optionally with a composition comprising an inorganic silicate before treatment with the organosilane bonding mixture in an inline spray system and evaluated against sample A described in example 1 of EP 0 431 501 B1 (i.e., no treatment with an inorganic silicate prior to deposition of an organosilane bonding mixture).

The chemical cleaning and treatment with an immersion tin composition used throughout all examples is summarized in table 1:

| Process step | Temperature [°C] | Process time [s] | Composition |
|---|---|---|---|
| Chemical cleaning: | | | |
| Acidclean UC (a product of Atotech Deutschland GmbH) | 35 | 17 | Acidic cleaner |
| Rinse | 25 | 35 | Water |

| Immersion tin treatment according to step (b): | | | |
|---|---|---|---|
| Secure Enhancer MSA (a product of Atotech Deutschland GmbH) | | | Comprising Sn²⁺ ions, MSA and thiourea |
| Rinse | 25 | 35 | Water |
| Rinse | 25 | 17 | DI water |

The process steps (c)-(d) applied in examples 1 to 5 are summarized in table 2:

| Process step | Temperature [°C] | Process time [s] | Composition |
|---|---|---|---|
| Treatment with inorganic silicate according to step (c): | | | |
| | 40 | 25 | Sodium metasilicate (x = 1) |
| Rinse | 25 | 17 | Water |

| Treatment with organosilane bonding mixture according to step (d) | | | |
|---|---|---|---|
| | 35 | 20 | Mixtures of 3-[Tri(ethoxy/methoxy)silyl]propyl]urea and 2-Bis(triethoxysilyl)ethane |
| Drying | 65 | 35 | |

In all experiments panels of type (i) or (ii) are laminated with ABF films after application of the inorganic silicate and the organosilane bonding mixture. Before lamination the panels are pre-warmed at 65°C for 5 min. The lamination is done with a hot roll laminator and a lamination speed of 1 m/min at 100°C roller temperature. The lamination of both panel sides requires two lamination steps. Afterwards the PET cover foil is removed.

After lamination the laminates are cured at 180 °C for 30 min in an oven with air circulation.

Next, all panels are treated two times with a desmear process and thereafter a plating through holes process is applied wherein copper is deposited with an electroless copper process and reinforced with 10 µm of electroplated copper.

Thermal annealing is applied after electroplating of copper. A three stage annealing is applied: 1^{st} annealing at 180°C for 60 min, 2^{nd} annealing at 200°C for 60 min and 3^{rd} annealing at 200°C for 60 min.

The blisters are counted then by optical inspection of the samples. Two types of blisters are observed: type one caused by local delamination of the ABF films from the tin layer (i.e., failure of the adhesion promoter layers), the other caused by delamination of the plated copper layers from the FR4 base material. Only blisters of type 1 are taken into account during examples 1 to 5.

### Example 1 (comparative)

In this example, the same organosilane bonding mixture described as sample A in example 1 of EP 0431 501 B1 comprising 1.0 wt.-% of 3-[Tri(ethoxy/methoxy)silyl]propyl]urea and 0.2 wt.-% 2-Bis(triethoxysilyl)ethane is deposited onto the oxidized tin surface. No treatment of type step (c) is applied.

Blisters are observed.

### Example 2 (comparative)

The panel is treated with an organosilane bonding mixture comprising 1.0 wt.-% of 3-[Tri(ethoxy/methoxy)silyl]propyl]urea and 1.0 wt.-% 2-Bis(triethoxysilyl)ethane in step (d). No treatment according to step (c) is applied.

Blisters are observed.

### Example 3

The same organosilane bonding mixture as used in Example 1 is applied. Prior to application of said organosilane bonding mixture, the panel is treated with a composition comprising 2 g/l sodium metasilicate (x = 1) according to step (c) of the process sequence as described on pages 2-3.

No blisters are observed.

### Example 4

The panel is treated with a composition comprising 2 g/l sodium metasilicate (x = 1) according to step (c) and an organosilane bonding mixture comprising 1.0 wt.-% of 3-[Tri(ethoxy/methoxy)silyl]propyl]urea and 1.0 wt.-% 2-Bis(triethoxysilyl)ethane in step (d) of the process sequence as described on pages 2-3.

No blisters are observed.

### Example 5

This example shows how the wettability of an oxidized tin surface is increased for organosilane bonding mixtures if a layer of an inorganic silicate is deposited on said oxidized tin surface prior to deposition of an organosilane bonding mixture.

A FR4 substrate having a copper surface is treated according to the process summarized in table 1. Afterwards, a composition comprising 2g/l of sodium metalsilicate (x = 1) is deposited onto the oxidized tin surface (deposition at T = 35 °C, t = 30 s), rinsed and dried. The wettability of a cleaned copper surface, an oxidized tin surface and a sodium metasilicate coated oxidized tin surface is compared by a sessile drop-test method using glycerine as the test liquid.

The contact angles against glycerine after 100 s are 85° (cleaned copper surface), 50° (oxidized tin surface) and 35° (oxidized tin surface coated with a composition comprising sodium metasilicate), respectively.

The lower the resulting contact angle against glycerine the better the wettability of the surface for a organosilane bonding mixture.

### Example 6

The enhanced resistance against humidity of a laminate prepared by the process according to the present invention is demonstrated by measuring the peel strength of the interface between a FR4 base substrate having a copper surface and a ABF film before and after applying a pressure cooker test.

The control sample is prepared according to tables 1 and 2 but without applying the coating of an inorganic silicate. A sample according to the process of the present invention is prepared according to the process described in tables 1 and 2.

Both kinds of samples are then subjected to a pressure cooker test according to Jedec Standard JESD22-A102-C 121°C, 100% RH, 205 kPa für 24 h). The peel strength his determined in accordance with IPC-TM-650 No. 2.4.8.

The peel strength for both types of samples after lamination is 13.33 N/cm and after pressure cooker test 10.75 N/cm for the control sample and 11.96 N/cm for the sample prepared according to the process of the present invention.

## Claims

1. A process for manufacture of a multilayer printed circuit board containing conductive through-holes which make electrical connectors to a series of electrically conducting layers through several insulating layers comprising the steps of:
(a) forming electrically conductive copper circuitry on a surface of a dielectric layer support with the circuitry having a thickness of at least 4 µm;
(b) forming on the copper circuitry a layer of an oxide, hydroxide or combination thereof of tin by application of tin to the copper circuitry whereby during application or subsequent thereto the applied tin is converted on its surface to the tin oxide, tin hydroxide or combination thereof with the proviso that the layer of tin oxide, tin hydroxide or combination is not greater than 40 µm in thickness;
(c) applying a mixture comprising at least one inorganic silicate to the surface of the oxide, hydroxide or combination thereof formed in step (b);
(d) applying an organosilane bonding mixture to the surface of the oxide, hydroxide or combination thereof formed in step (c);
(e) repeating steps (a), (b), (c) and (d) at least once;
(f) bonding materials formed by steps (a), (b), (c), (d) and (e) into a single article whereby an organosilane coating is between a layer of the oxide, hydroxide or combination and an insulating layer whereby during bonding the partially cured insulating layer is cured;
the silane bonding mixture is consisting essentially of:
(I) at least one ureido silane having the structure of formula I 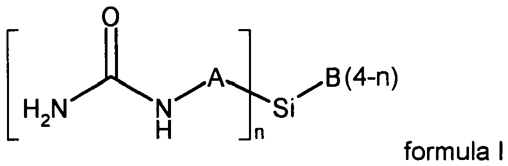 wherein A is an alkylene having 1 to 8 carbon atoms, B is a hydroxyl or an alkoxy having 1 to 8 carbon atoms and n is an integer of 1, 2 or 3 with the provisio that if n is 1 or 2, each B need not be identical; and
(II) at least one crosslinking agent, selected from the group consisting of compounds having the structure of formula II 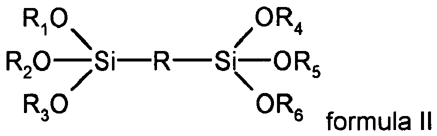
wherein R1, R2, R3, R4, R5 and R6 independently of the other is an alkyl with 1 to 8 carbon atoms and where R denotes an alkylene group having 1 to 8 carbon atoms, compounds having the formula III
Si(OR7)₄ formula III
wherein R7 is selected from the group consisting of methyl, ethyl and propyl, and mixtures of compounds having the formula II and III.

2. The process according to claim 1, wherein the overall concentration of ureido silanes having the structure of formula I crosslinking agents having the structures of formula II and formula III ranges between 1 and 50 g/l.

3. The process according to claim 1, wherein the at least one inorganic silicate used in step (c) is selected from the group having the general formula xM₂O · SiO₂ · nH₂O, wherein x ranges from 1 to 4, n ranges from 0 to 9 and M is selected from the group consisting of Na⁺, K⁺ and NH₄⁺.

4. The process according to any of the foregoing claims wherein the composition used in step (c) further comprises at least one water-soluble phosphate compound.

5. The process according to claim 4 wherein the at least one water-soluble phosphate compound is selected from the group consisting of sodium phosphate, potassium phosphate, ammonium phosphate, dibasic sodium phosphate, tribasic sodium phosphate, dibasic potassium phosphate, tribasic potassium phosphate, ammonium dibasic phosphate, ammonium tribasic phosphate, sodium tripolyphosphate, potassium tripolyphosphate and ammonium tripolyphosphate.

6. The process according to any of the foregoing claims wherein the weight-ratio of the at least one ureido silane and the at least one crosslinking agent ranges between 10:1 and 1:1.

7. The process according to claim 5, wherein the ureido silane is 3-[Tri(ethoxy/methoxy)silyl]propyl]urea.

8. The process according to claim 6, wherein the crosslinking agent is 2-Bis(triethoxysilyl)ethane.

9. The process according to any of the foregoing claims, wherein the process comprises the further steps after step (f):
(g) forming a number of holes through the bonded article formed in step (f);
(h) metallizing walls of the through-holes to form electrically conductive paths from opposite openings of the through-holes to form a multilayer circuit board.

## Patentansprüche

1. Verfahren zur Herstellung einer mehrschichtigen Leiterplatte mit leitfähigen Durchgangslöchern, die elektrische Verbindungen zu einer Reihe von elektrisch leitfähigen Schichten durch mehrere Isolierschichten bilden, umfassend die folgenden Schritte:
(a) Bilden einer elektrisch leitfähigen Kupfer-Schaltungsanordnung auf einer Oberfläche eines dielektrischen Schichtträgers, wobei die Schaltungsanordnung eine Dicke von mindestens 4 µm aufweist;
(b) Bilden einer Schicht aus einem Zinnoxid und/oder Zinnhydroxid durch Aufbringen von Zinn auf die Kupfer-Schaltungsanordnung, wobei das aufgebrachte Zinn während des Auftragens oder danach an seiner Oberfläche in das Zinnoxid und/oder Zinnhydroxid davon umgewandelt wird, mit der Maßgabe, dass die Schicht aus Zinnoxid und/oder Zinnhyroxid eine Dicke von höchstens 40 µm aufweist;
(c) Aufbringen einer Mischung, die mindestens ein anorganisches Silikat umfasst, auf die Oberfläche des in Schritt (b) gebildeten Oxids und/oder Hydroxids;
(d) Aufbringen einer Organosilan-Verbindungsmischung auf die Oberfläche des in Schritt (c) gebildeten Oxids und/oder Hydroxids;
(e) mindestens einmaliges Wiederholen der Schritte (a), (b), (c) und (d);
(f) Verbinden von durch die Schritte (a), (b), (c), (d) und (e) gebildeten Materialien zu einem einzigen Gegenstand, wobei sich eine Organosilan-Beschichtung zwischen einer Schicht des Oxids und/oder Hydroxids und einer Isolierschicht befindet, wobei die teilweise gehärtete Isolierschicht während des Verbindens gehärtet wird;
wobei die Silan-Verbindungsmischung im Wesentlichen aus:
(I) mindestens einem Ureidosilan mit der Struktur von Formel I 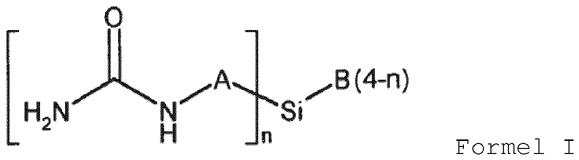 worin A für ein Alkylen mit 1 bis 8 Kohlenstoffatomen steht, B für ein Hydroxyl oder ein Alkoxy mit 1 bis 8 Kohlenstoffatomen steht und n für eine ganze Zahl mit einem Wert von 1, 2 oder 3 steht, mit der Maßgabe, dass dann, wenn n für 1 oder 2 steht, jedes B nicht identisch zu sein braucht; und
(II) mindestens einem Vernetzungsmittel aus der Gruppe bestehend aus Verbindungen mit der Struktur von Formel II 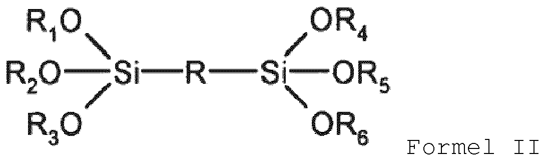 worin R₁, R₂, R₃, R₄, R₅ und R₆ unabhängig voneinander für ein Alkyl mit 1 bis 8 Kohlenstoffatomen stehen und R für eine Alkylengruppe mit 1 bis 8 Kohlenstoffatomen steht, Verbindungen mit der Formel III
Si(OR₇)₄ Formel III
worin R₇ aus der Gruppe bestehend aus Methyl, Ethyl und Propyl ausgewählt ist, und Mischungen von Verbindungen mit der Formel II und III besteht.

2. Verfahren nach Anspruch 1, wobei die Gesamtkonzentration an Ureidosilanen mit der Struktur von Formel I und Vernetzungsmitteln mit den Strukturen der Formel II und Formel III zwischen 1 und 50 g/l liegt.

3. Verfahren nach Anspruch 1, wobei das mindestens eine anorganische Silikat, das in Schritt (c) verwendet wird, aus der Gruppe mit der allgemeinen Formel xM₂O·SiO₂·nH₂O ausgewählt wird, wobei x im Bereich von 1 bis 4 liegt, n im Bereich von 0 bis 9 liegt und M aus der Gruppe bestehend aus Na⁺, K⁺ und NH₄⁺ ausgewählt ist.

4. Verfahren nach einem der vorhergehenden Ansprüche, wobei die in Schritt (c) verwendete Zusammensetzung ferner mindestens eine wasserlösliche Phosphatverbindung umfasst.

5. Verfahren nach Anspruch 4, wobei die mindestens eine wasserlösliche Phosphatverbindung aus der Gruppe bestehend aus Natriumphosphat, Kaliumphosphat, Ammoniumphosphat, Dinatriumhydrogenphosphat, Trinatriumphosphat, Dikaliumhydrogenphosphat, Trikaliumphosphat, Diammoniumhydrogenphosphat, Triammoniumphosphat, Natriumtripolyphosphat, Kaliumtripolyphosphat und Ammoniumtripolyphosphat ausgewählt wird.

6. Verfahren nach einem der vorhergehenden Ansprüche, wobei das Gewichtsverhältnis des mindestens einen Ureidosilans und des mindestens einen Vernetzungsmittels im Bereich zwischen 10:1 und 1:1 liegt.

7. Verfahren nach Anspruch 5, wobei es sich bei dem Ureidosilan um 3-[Tri(ethoxy/methoxy)silyl]-propyl]harnstoff handelt.

8. Verfahren nach Anspruch 6, wobei es sich bei dem Vernetzungsmittel um 2-Bis(triethoxysilyl)ethan handelt.

9. Verfahren nach einem der vorhergehenden Ansprüche, wobei das Verfahren ferner nach Schritt (f) die folgenden weiteren Schritte umfasst:
(g) Bilden einer Anzahl von Löchern durch den in Schritt (f) gebildeten verbundenen Gegenstand;
(h) Metallisieren der Wände der Durchgangslöcher zur Bildung von elektrisch leitfähigen Bahnen von gegenüberliegenden Öffnungen der Durchgangslöcher zur Bildung einer mehrschichtigen Leiterplatte.

## Revendications

1. Procédé de fabrication d'une carte de circuit imprimé multicouche contenant des trous débouchants conducteurs qui constituent des connecteurs électriques pour une série de couches électriquement conductrices à travers plusieurs couches isolantes, comprenant les étapes consistant à :
(a) former un circuit électriquement conducteur en cuivre sur une surface d'un support de couche diélectrique, le circuit ayant une épaisseur d'au moins 4 µm ;
(b) former sur le circuit en cuivre une couche d'un oxyde ou hydroxyde d'étain ou d'une combinaison de ceux-ci par application d'étain au circuit en cuivre, l'étain appliqué étant, durant l'application ou après celle-ci, transformé sur sa surface en l'oxyde d'étain, l'hydroxyde d'étain ou la combinaison de ceux-ci, à condition que la couche d'oxyde d'étain, d'hydroxyde d'étain ou de combinaison n'ait pas une épaisseur supérieure à 40 µm ;
(c) appliquer un mélange comprenant au moins un silicate inorganique à la surface de l'oxyde, de l'hydroxyde ou de la combinaison de ceux-ci, formé à l'étape (b) ;
(d) appliquer un mélange liant à base d'organosilane à la surface de l'oxyde, de l'hydroxyde ou de la combinaison de ceux-ci, formé à l'étape (c) ;
(e) répéter les étapes (a), (b), (c) et (d) au moins une fois ;
(f) assembler les matériaux formés par les étapes (a), (b), (c), (d) et (e) en un seul article, un revêtement d'organosilane se situant entre une couche de l'oxyde, de l'hydroxyde ou de la combinaison et une couche isolante, la couche isolante partiellement durcie étant durcie durant l'assemblage ;
le mélange liant à base de silane étant essentiellement constitué par :
(I) au moins un uréidosilane ayant la structure de formule I 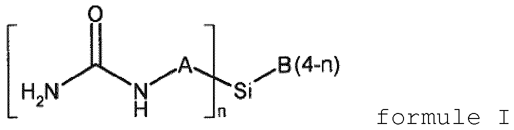 dans laquelle A représente un alkylène portant 1 à 8 atomes de carbone, B représente un hydroxyle ou un alcoxy portant 1 à 8 atomes de carbone, et n est un entier valant 1, 2 ou 3, à condition que si n vaut 1 ou 2, tous les B ne soient pas nécessairement identiques ; et
(II) au moins un agent de réticulation choisi dans le groupe constitué par les composés ayant la structure de formule II 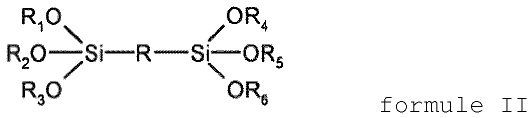 dans laquelle R1, R2, R3, R4, R5 et R6, indépendamment les uns des autres, représentent un alkyle portant 1 à 8 atomes de carbone, et R représente un groupe alkylène portant 1 à 8 atomes de carbone, les composés répondant à la formule III
Si(OR7)₄ formule III
dans laquelle R7 est choisi dans le groupe constitué par les radicaux méthyle, éthyle et propyle, et les mélanges des composés répondant aux formules II et III.

2. Procédé selon la revendication 1, dans lequel la concentration globale des uréidosilanes ayant la structure de formule I et des agents de réticulation ayant les structures de formule II et de formule III varie entre 1 et 50 g/l.

3. Procédé selon la revendication 1, dans lequel l'au moins un silicate inorganique utilisé à l'étape (c) est choisi dans le groupe répondant à la formule générale xM₂O·SiO₂·nH₂O dans laquelle x va de 1 à 4, n va de 0 à 9 et M est choisi dans le groupe constitué par Na⁺, K⁺ et NH₄⁺.

4. Procédé selon l'une quelconque des revendications précédentes dans lequel la composition utilisée à l'étape (c) comprend en outre au moins un composé de phosphate hydrosoluble.

5. Procédé selon la revendication 4 dans lequel l'au moins un composé de phosphate hydrosoluble est choisi dans le groupe constitué par le phosphate de sodium, le phosphate de potassium, le phosphate d'ammonium, le phosphate de sodium dibasique, le phosphate de sodium tribasique, le phosphate de potassium dibasique, le phosphate de potassium tribasique, le phosphate d'ammonium dibasique, le phosphate d'ammonium tribasique, le tripolyphosphate de sodium, le tripolyphosphate de potassium et le tripolyphosphate d'ammonium.

6. Procédé selon l'une quelconque des revendications précédentes dans lequel le rapport pondéral entre l'au moins un uréidosilane et l'au moins un agent de réticulation varie entre 10:1 et 1:1.

7. Procédé selon la revendication 5 dans lequel l'uréidosilane est la 3-[tri(éthoxy/méthoxy)silyl]propyl-urée.

8. Procédé selon la revendication 6 dans lequel l'agent de réticulation est le 2-bis(triéthoxysilyl)éthane.

9. Procédé selon l'une quelconque des revendications précédentes, le procédé comprenant, après l'étape (f), les étapes supplémentaires suivantes :
(g) former un certain nombre de trous à travers l'article assemblé formé à l'étape (f) ;
(h) métalliser les parois des trous débouchants pour constituer des chemins électriquement conducteurs depuis des ouvertures opposées des trous débouchants afin de former une carte de circuit multicouche.
